# EUROPEAN PATENT SPECIFICATION

(11) **EP 3 117 454 B1**
(45) Date of publication and mention of the grant of the patent: **03.06.2020**
(21) Application number: 15811731.7
(22) Date of filing: 23.04.2015
(51) Int. Cl.: H01L 21/66

(54) **PATTERNED WAFER GEOMETRY MEASUREMENTS FOR SEMICONDUCTOR PROCESS CONTROLS**
GEOMETRISCHE MESSUNGEN VON STRUKTURIERTEN WAFERN ZUR HALBLEITERPROZESSKONTROLLE
MESURES GÉOMÉTRIQUES DE PLAQUETTES À MOTIFS POUR CONTRÔLE DE PROCESSUS À SEMI-CONDUCTEUR

(30) Priority: 24.06.2014 US 201414313733
(43) Date of publication of application: 18.01.2017
(73) Proprietor: Kla-Tencor Corporation, Milpitas, California 95035 (US)
(72) Inventor: VUKKADALA, Pradeep, Cupertino, CA 95014 (US); SINHA, Jaydeep, Livermore, California 94550 (US)
(74) Representative: FRKelly
(86) International application number: PCT/US2015/027182
(87) International publication number: WO 2015/199801

(56) References cited:
- JP-B2- 3 316 833
- US-A1- 2003 186 624
- US-A1- 2004 185 662
- US-A1- 2004 185 662
- US-A1- 2004 239 905
- US-A1- 2005 128 456
- US-A1- 2005 128 456
- US-A1- 2005 255 610
- US-A1- 2005 255 610
- US-A1- 2011 172 982

## Description

### TECHNICAL FIELD

The disclosure generally relates to the field of semiconductors, and particularly to wafer geometry measurement techniques.

### BACKGROUND

Fabricating semiconductor devices typically includes processing a substrate such as a semiconductor wafer using a number of semiconductor fabrication processes. For example, lithography is a semiconductor fabrication process that involves transferring a pattern from a reticle to a resist arranged on a semiconductor wafer. Additional examples of semiconductor fabrication processes include, but are not limited to, chemical-mechanical polishing (CMP), etching, deposition, and ion implantation. Multiple semiconductor devices may be fabricated in an arrangement on a single semiconductor wafer and then separated into individual semiconductor devices.

Metrology processes are used at various steps during a semiconductor manufacturing process to monitor and control one or more semiconductor layer processes. Some of these characteristics include the flatness and thickness uniformity of the wafers. While conventional metrology systems may be able to monitor and control these characteristics, they are generally utilized for handling unpatterned/bare wafers. Therein lies a need for systems and methods for wafer geometry measurements suitable for any wafers, including patterned wafers, without the aforementioned shortcomings.

US2004/185662 discloses a wafer flatness evaluation method includes measuring front and rear surface shapes of a wafer. The wafer front surface measured is divided into sites. Then, a flatness calculating method is selected according to a position of the site to be evaluated and flatness in the wafer surface is acquired.

US 2005/255610 A1 discloses a wafer flatness evaluation method comprising measuring frontside and backside heights.

### SUMMARY

The invention is set out in the appended claims 1-12.

It is to be understood that both the foregoing general description and the following detailed description are exemplary and explanatory. The accompanying drawings, which are incorporated in and constitute a part of the specification, illustrate subject matter of the disclosure. Together, the descriptions and the drawings serve to explain the principles of the disclosure.

### BRIEF DESCRIPTION OF THE DRAWINGS

The numerous advantages of the disclosure may be better understood by those skilled in the art by reference to the accompanying figures in which:
FIG. 1 is an illustration depicting a wafer flatness measured on a patterned wafer geometry measurement tool;
FIG. 2 is an illustration depicting a wafer polishing process;
FIG. 3 is a block diagram depicting a wafer geometry measurement based control loop for a wafer polishing process;
FIG. 4 is block diagram depicting a wafer geometry measurement based control loop for a lithography scanner;
FIG. 5 is a flow diagram depicting a method for estimating flatness errors that takes flatness signatures of a lithography chuck into consideration;
FIG. 6 is an illustration depicting a site-based flatness variation calculation process;
FIG. 7 is an illustration that continues the depiction of the site-based flatness variation calculation process; and
FIG. 8 is an illustration that continues the depiction of the site-based flatness variation calculation process.

### DETAILED DESCRIPTION

Reference will now be made in detail to the subject matter disclosed, which is illustrated in the accompanying drawings.

Embodiments of the present disclosure are directed to systems and methods for providing improved wafer geometry measurements for lithography focus, CMP, and other semiconductor process control scanner corrections. It is noted that the term wafer geometry in the present disclosure refers to wafer front side height, backside height, thickness variation, flatness, and all consequent derivatives such as shape, topography, or the like. It is also noted that the systems and methods in accordance with embodiments of the present disclosure are suitable for handling any types of wafers, including patterned wafers, without the shortcomings of conventional metrology systems.

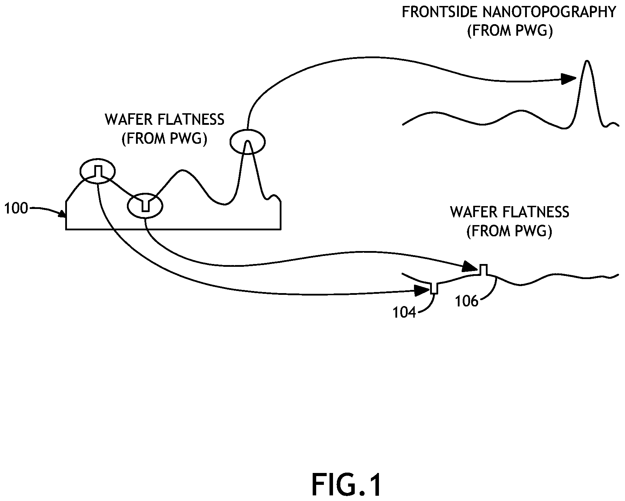

Referring to FIG. 1, a wafer flatness measured on a patterned wafer geometry (PWG) measurement tool is shown. A patterned wafer geometry measurement tool utilized in accordance with the present disclosure is a measurement tool that is able to measure front side height, back side height, and thickness variation of the wafer. Obtaining such information allows the sources of flatness errors to be separated and attributed to front side and backside components.

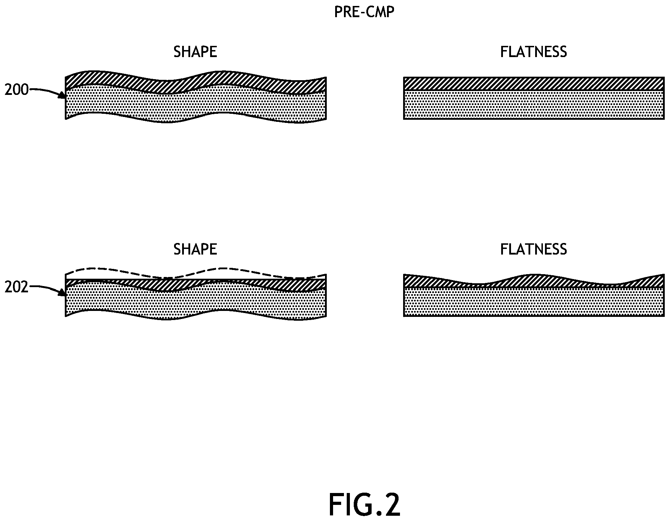

The ability to identify the sources of flatness errors is important. For instance, referring to FIG. 2, a simplified illustration depicting a wafer 200 being polished by a polishing tool (e.g., CMP) is shown. Suppose that the shape of the wafer 200 before going through the polishing process is slightly curved as shown, the polishing tool will then remove the raised portions of the top surface, resulting in a polished wafer 202 with a flat front side. However, this polished wafer 202 is undesirable because its flatness profile is suboptimal.

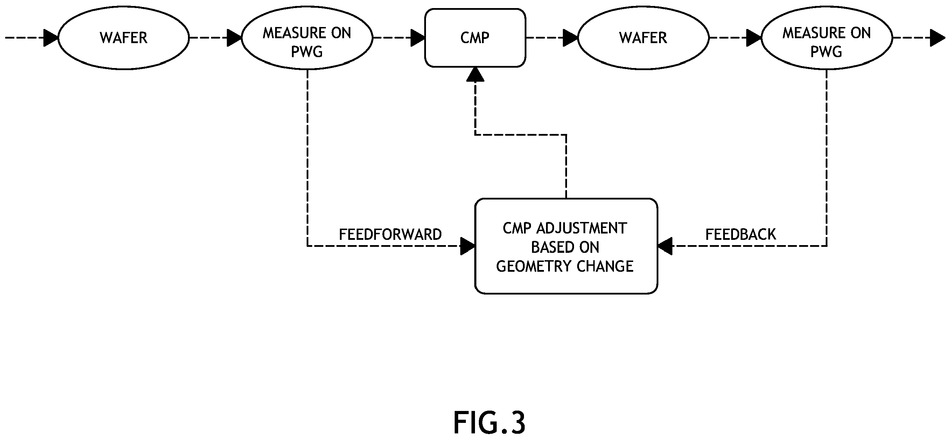

Instead of simply removing the raised portions of the top surface, wafer geometry and flatness data should be measured and taken into consideration for the polishing process. FIG. 3 is an illustration depicting such a control loop. More specifically, the separate front side and backside topography measurement data can be obtained and feed to the control loop to optimize the polishing process. For instance, the control loop may calculate a best-flatness condition that can be achieved if the wafer is polished in a certain manner. Subsequently, different pressure levels can be applied to different areas of the wafer so that the best-flatness condition can be achieved as an end result, as opposed to simply providing a flat top surface 202 as depicted in FIG. 2. In addition, wafer geometry measurements can be taken again after the polishing process; and adjustments necessary can be determined and applied to the polishing process accordingly.

It is contemplated that configuring the polishing tool in this manner to optimize for the best-flatness condition is beneficial for downstream processes. For example, a polished wafer will be held on a vacuum or a chuck using force when it is processed by a lithography process tool or the like. It is noted that when the wafer is held on a chuck using force, the wafer backside is expected to be substantially flattened, and if the wafer was simply polished to provide a flat top surface, the top surface may no longer be flat when the wafer is chucked. Focus errors may be introduced as a result. Since wafer flatness errors directly contribute to focus errors during lithography exposure, configuring the polishing tool based on optimizing flatness conditions as described above effectively improves focus of the lithography process tool.

It is also contemplated that when the wafer is chucked, features such as 104 and 106 (as shown in FIG. 1) that are induced by the wafer backside are pushed towards the front side and are presented to the lithography process tool along with the features that are induced by the wafer front side. While certain lithography process tools are capable of making adjustments based on wafer flatness to compensate for errors, it is noted that these adjustments are made without distinguishing between the front side induced flatness errors and the backside induced flatness errors. Therefore, adjustments made in this manner is not ideal because once the wafer is unchucked, compensations made while the wafer was chucked may turn out to be over-corrected or under-corrected.

With the ability to separate the front side topography from the backside topography, as shown in FIG. 1, the sources of flatness errors can be isolated. In the example shown in FIG. 1, once it is observed that the backside has distinct signatures (pin-type marks) 104 and 106, a subsequent process step may be notified of this observation (e.g., in a feedforward manner) and the subsequent process step may choose to compensate for (or avoid) such flatness errors accordingly.

In addition to providing a better compensation control mechanism, separating the front side topography from the backside topography can also help identifying process steps that may have caused front side and/or backside flatness errors during the manufacturing process. In the example shown in FIG. 1, once it is determined that the signatures (pin-type marks) 104 and 106 are induced by the backside, an analysis process may be invoked to find the cause of such signatures. In one embodiment, this analysis process (may be referred to as a cause analysis or root cause analysis) may attempt to identify which process step(s) during the manufacturing process caused these errors and by how much. For instance, this analysis process may take wafer geometry measurements at suspected process steps and identify the process step(s) that caused the backside signatures. It is contemplated that this process may also be utilized to analyze the front side errors as well.

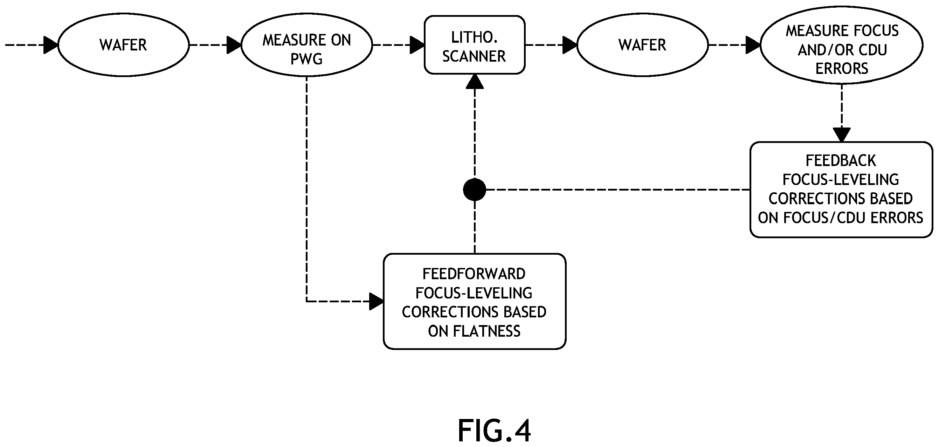

FIGS. 3 and 4 are illustrations depicting control loops that may be utilized to analyze/assess wafer geometry variations induced by various types of process steps. By measuring wafer geometry at two points, i.e., before and after a process of interest, the variations induced by that particular process step to wafer geometry can be assessed. The measured changes in wafer geometry may be related to impact on critical semiconductor fabrication parameters such as lithography focus and overlay errors, and yield by way of metrics such as site-flatness, in-plane displacement and the like that may be computed from the measured wafer geometry changes.

It is contemplated that such an analysis process may be utilized in every critical process steps during the manufacturing process to catch potential errors as soon as possible. Alternatively or additionally, this analysis process may be conditionally invoked when certain signatures are detected on either the front side or the backside. As previously mentioned, in the example shown in FIG. 1, when the signatures (pin-type marks) 104 and 106 are detected on the backside of the wafer 100, this detection may prompt further analysis to find the cause of such signatures. Furthermore, it may be configured to manually and/or automatically adjust process step conditions for a particular process tool and thereby minimize the impact of that particular process tool on wafer geometry and certain critical semiconductor fabrication parameters.

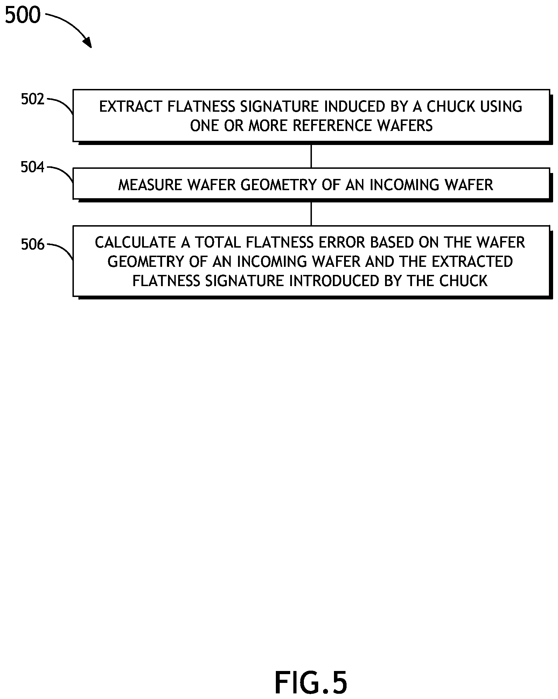

In addition to providing abilities to identify and to compensate for flatness errors, flatness signatures induced by a chuck can also be extracted and used to calculate/estimate a total flatness error of an incoming wafer. More specifically, FIG. 5 shows a methodology in which wafer flatness measurements obtained using a wafer geometry tool and scanner leveling measurements obtained from the lithography scanner can be used to calculate/estimate flatness errors. It is contemplated that patterned wafers or unpatterned bare wafers (serving as reference wafers) may be used to extract the flatness signature induced by a given chuck in step 502. Once the flatness signature of the given chuck has been extracted, total flatness errors during lithography exposures for future wafers chucked on that same chuck may be estimated. For example, when a new wafer is received, its wafer geometry, including its measured flatness, can be obtained in step 504 using a wafer geometry tool. Subsequently, by adding the extracted chuck flatness signature to the measured flatness of that wafer, the total flatness error (representing the flatness errors when the wafer is chucked) can be calculated in step 506. In this manner, the effects of forcing the wafer onto the chuck can be quantified (e.g., as a part of the feedforward control), which can help providing better focus leveling corrections.

It is noted that this calculation is also fully reversible. That is, if the height of the top surface is measured when the wafer is chucked on a particular chuck (e.g., based on scanner leveling measurements), and if the wafer geometry has been measured when the wafer was in an unchucked state, the flatness signature of that particular chuck can be calculated by subtracting the measured wafer geometry from the leveling map obtained from the lithography scanner. As previously mentioned, this process can be carried out using reference wafers in a controlled manner, and the extracted flatness signature of that particular chuck can be used to predict/estimate its effects on future wafers. In addition, the accuracy of this estimation process can be improved utilizing a feedback loop (e.g., as shown in FIG. 4). More specifically, focus error and/or critical dimension uniformity can be measured post-lithography to check how well the feedforward focus corrections worked. If it is determined that the feedforward alone did not sufficiently reduce focus and/or critical dimension uniformity errors, then the feedback loop may be employed that will adjust the focus corrections for the next wafer.

It is also contemplated that additional measurement metrics may also be obtained and provided as control signals. For instance, in one embodiment, a site-based flatness variation metric is obtained, which can be used to perform root cause analysis and/or provided as feedback to improve the manufacturing processes.

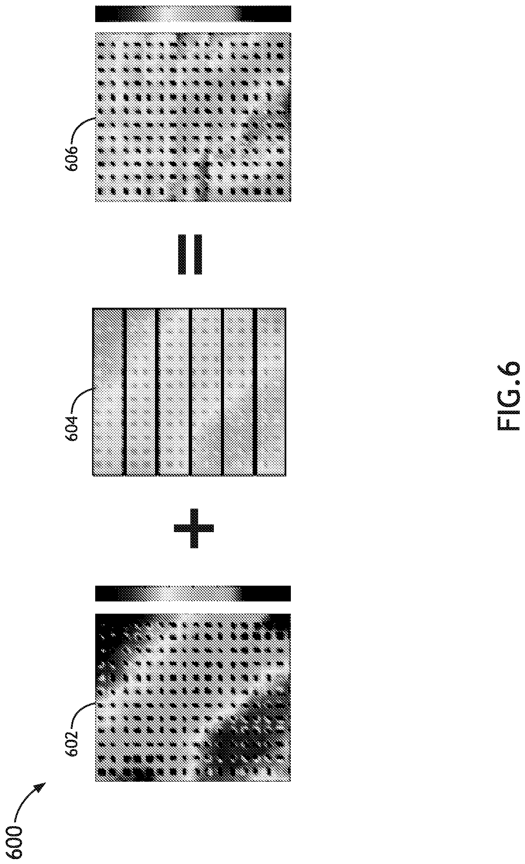

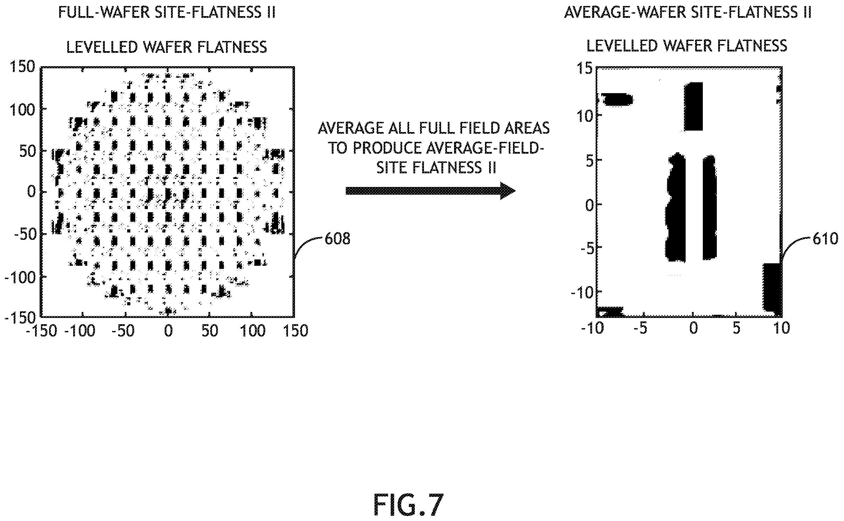

Referring to FIGS. 6 through 8, a series of illustrations depicting a site-based flatness variation calculation process 600 is shown. In step 602, a wafer-level thickness variation map is obtained and divided into a plurality of uniform sized sites (may also be referred to as fields). The thickness variation within each particular site is then leveled by fitting a single least-square best-fit plane to that particular site. In step 604, each site is further divided into rectangular areas generally equivalent to the slit-size of the lithography scanner. It is understood that if a site cannot be evenly divided by the slit-size, a partial slit may be utilized on one end of the site, or the slit-size may be slightly adjusted to evenly divide the site. It is noted that one of the advantages provided by dividing the sites in this manner is that it simulates the scanning process, which is done in a slit-by-slit manner.

Now, each slit-area can be further leveled independently by fitting a single least-square best-fit plane to that particular slit-area in step 606, and the independently leveled slit-areas within each site can be combined to form a full wafer map (e.g., representing industry standard metrics such as site frontside least squares focal plane, or SFQ and the like) in step 608. Subsequently, an average site-flatness value is taken by averaging all site-flatness values in step 610. It is noted that this average site-flatness value is leveled utilizing both conventional site-wise leveling and slit-by-slit leveling (which has the advantage of simulating the scanning process) as described above.

It is contemplated that the average site-flatness value calculated in this manner can be utilized to compute various derived metrics and information regarding a given wafer. For instance, by subtracting the average value from each site-based value, as shown in step 612, a site-to-site variation map can be calculated for the full wafer. It is also contemplated that while flatness values are used as exemplary measurement metrics, this site-based, slit-by-slit variation calculation process is applicable for calculation of various other types of measurement metrics, including, but not limited to flatness variations, thickness variations, as well as various other types of wafer topography variations that correlate to non-correctable focus errors seen by the lithography scanner during wafer exposure.

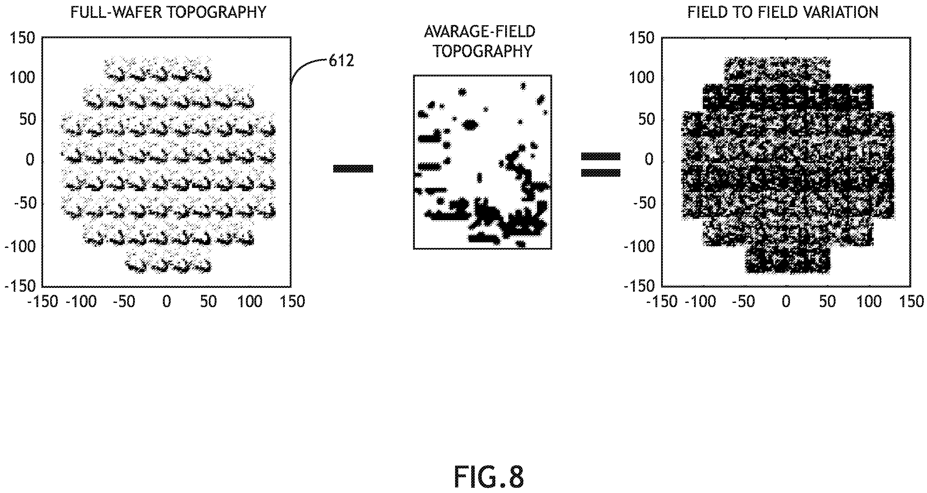

It is also contemplated that these variation maps can be used for reporting purposes, and can also be analyzed to improve the manufacturing processes. For example, in the site-to-site variation map shown in FIG. 8, the topography variation (which is systematic) coming from the device pattern is removed. Thereby any process variability (such as a local hot-spot created by a polishing tool) becomes visible after the systematic topography is removed. This information can then be provided as a feedback control to the polishing tool, thereby improving future processes.

It is further contemplated that the average-site and site-to-site variation maps and metrics are not limited to flatness measurements. The same techniques described above are also applicable to other metrics for front side and/or backside maps such front and/or back nanotopography and the like.

It is contemplated that while the examples above referred to polishing tools and lithography tools, the systems and methods in accordance with the present disclosure are applicable to other types of process tools, which may also benefit from the wafer geometry based control loops. Furthermore, the term wafer used in the present disclosure may include a thin slice of semiconductor material used in the fabrication of integrated circuits and other devices, as well as other thin polished plates such as magnetic disc substrates, gauge blocks and the like.

The methods disclosed may be implemented in various wafer geometry measurement tools as sets of instructions executed by one or more processors, through a single production device, and/or through multiple production devices. Further, it is understood that the specific order or hierarchy of steps in the methods disclosed are examples of exemplary approaches. Based upon design preferences, it is understood that the specific order or hierarchy of steps in the method can be rearranged. The accompanying method claims present elements of the various steps in a sample order, and are not necessarily meant to be limited to the specific order or hierarchy presented.

It is believed that the system and method of the present disclosure and many of its attendant advantages will be understood by the foregoing description, and it will be apparent that various changes may be made in the form, construction and arrangement of the components. The form described is merely explanatory.

## Claims

1. A method for controlling lithography focus errors, the method comprising:
obtaining a first set of wafer geometry measurements of a wafer prior to lithography scanning, the first set of wafer geometry measurements including: a first front side height measurement, a first backside height measurement, and a first wafer flatness measurement;
identifying at least one wafer flatness error; and
controlling a lithography scanner to compensate for the at least one wafer flatness error during lithography scanning;
wherein identifying at least one wafer flatness error comprises:
obtaining a wafer-level thickness variation map;
dividing the wafer-level thickness variation map into a plurality of uniform sized sites;
independently leveling each site of the plurality of sites;
further dividing each site into a plurality of rectangular areas, wherein each rectangular area generally corresponds to a slit-size of a lithography scanner;
independently leveling each rectangular area of the plurality of rectangular areas for each site of the plurality of sites; and
combining the plurality of rectangular areas of each site of the plurality of sites to obtain a full wafer measurement metric.

2. The method of claim 1, wherein identifying at least one wafer flatness error further comprises:
estimating at least one lithography chuck induced flatness error; and
calculating a total wafer flatness error based on the at least one lithography chuck induced flatness error and the first wafer flatness measurement.

3. The method of claim 2, wherein the at least one lithography chuck induced flatness error is estimated by subtracting wafer geometry of a reference wafer measured in an unchucked state from a leveling map of the reference wafer obtained from the lithography scanner when the reference wafer is chucked.

4. The method of claim 1, further comprising:
obtaining at least one of: a focus error and a critical dimension uniformity, after lithography scanning.

5. The method of claim 4, further comprising:
determining an effectiveness of said controlling the lithography scanner to compensate for the at least one wafer flatness error during lithography scanning based on said at least one of: the focus error and the critical dimension uniformity, obtained after lithography scanning; and
adjusting the lithography focus based on said at least one of: the focus error and the critical dimension uniformity, obtained after lithography scanning.

6. The method of claim 1, wherein independently leveling each site of the plurality of sites comprises fitting a single least-square best-fit plane to each site.

7. The method of claim 1, wherein independently leveling each rectangular area of the plurality of rectangular areas for each site of the plurality of sites comprises fitting a single least-square best-fit plane to each rectangular area.

8. The method of claim 1, wherein the full wafer measurement metric includes a full wafer flatness measurement metric.

9. The method of claim 8, further comprising:
calculating an average site-flatness value based on the full wafer flatness measurement metric.

10. The method of claim 9, further comprising:
subtracting the average site-flatness value from the full wafer flatness measurement metric to obtain a site-to-site variation.

11. The method of claim 10, further comprising:
providing the site-to-site variation as a feedback control to a process tool to reduce process tool induced flatness errors.

12. A system comprising:
a patterned wafer geometry measurement tool; and
one or more processors configured to execute a set of instructions, wherein the set of instructions are configured to cause the one or more processors to implement the method as claimed in any one of claims 1-11, wherein the first set of wafer geometry measurements of the wafer is obtained from the patterned wafer geometry tool.

## Patentansprüche

1. Verfahren zum Kontrollieren von Lithographiefokusfehlern, wobei das Verfahren Folgendes umfasst:
Erlangen eines ersten Satzes von Wafergeometriemessungen eines Wafers vor einem Scannen der Lithographie, wobei der erste Satz von Wafergeometriemessungen Folgendes beinhaltet: eine erste Vorderseitenhöhenmessung, eine erste Rückseitenhöhenmessung und eine erste Waferplanitätsmessung;
Identifizieren mindestens eines Waferplanitätsfehlers; und
Kontrollieren eines Lithographiescanners, um den mindestens einen Waferplanitätsfehler während des Scannens der Lithographie auszugleichen;
wobei das Identifizieren mindestens eines Waferplanitätsfehlers umfasst:
Erlangen einer Waferebene-Dickenabweichungsabbildung;
Teilen der Waferebene-Dickenabweichungsabbildung in eine Vielzahl von einheitlich großen Stellen;
unabhängiges Einebnen jeder Stelle der Vielzahl von Stellen;
weiteres Teilen jeder Stelle in eine Vielzahl von rechteckigen Flächen, wobei jede rechteckige Fläche allgemein einer Spaltgröße eines Lithographiescanners entspricht;
unabhängiges Einebnen jeder rechteckigen Fläche der Vielzahl von rechteckigen Flächen für jede Stelle der Vielzahl von Stellen; und
Kombinieren der Vielzahl von rechteckigen Flächen jeder Stelle der Vielzahl von Stellen, um eine Messgröße einer vollständigen Wafermessung zu erlangen.

2. Verfahren nach Anspruch 1, wobei das Identifizieren mindestens eines Waferplanitätsfehlers ferner umfasst:
Schätzen mindestens eines durch eine Lithographieauflage induzierten Planitätsfehlers; und
Berechnen eines Gesamt-Waferplanitätsfehlers auf Grundlage des mindestens einen durch eine Lithographieauflage induzierten Planitätsfehlers und der ersten Waferplanitätsmessung.

3. Verfahren nach Anspruch 2, wobei der mindestens eine durch eine Lithographieauflage induzierte Planitätsfehler durch Subtrahieren der Wafergeometrie eines Referenzwafers, gemessen in einem nicht eingespannten Zustand, von einer Einebnungsabbildung des Referenzwafers, erlangt von dem Lithographiescanner, wenn der Referenzwafer eingespannt ist, geschätzt wird.

4. Verfahren nach Anspruch 1, ferner umfassend:
Erlangen mindestens eines von Folgenden: einen Fokusfehler und eine kritische Abmessungseinheitlichkeit nach dem Scannen der Lithographie.

5. Verfahren nach Anspruch 4, ferner umfassend:
Bestimmen einer Wirksamkeit des Kontrollierens des Lithographiescanners, um den mindestens einen Waferplanitätsfehler während des Scannens der Lithographie auf Grundlage des mindestens einen von Folgenden auszugleichen: dem Fokusfehler und der nach dem Scannen der Lithographie erlangten kritischen Abmessungseinheitlichkeit;
und
Einstellen des Lithographiefokus auf Grundlage des mindestens einen von Folgenden: dem Fokusfehler und der nach dem Scannen der Lithographie erlangten kritischen Abmessungseinheitlichkeit.

6. Verfahren nach Anspruch 1, wobei das unabhängige Einebnen jeder Stelle der Vielzahl von Stellen ein Anpassen einer einzelnen Ebene mit bester Übereinstimmung der Fehlerquadrate an jede Stelle umfasst.

7. Verfahren nach Anspruch 1, wobei das unabhängige Einebnen jeder rechteckigen Fläche der Vielzahl von rechteckigen Flächen für jede Stelle der Vielzahl von Stellen ein Anpassen einer einzelnen Ebene mit bester Übereinstimmung der Fehlerquadrate an jede rechteckige Fläche umfasst.

8. Verfahren nach Anspruch 1, wobei die Messgröße der vollständigen Wafermessung eine Messgröße einer vollständigen Waferplanitätsmessung beinhaltet.

9. Verfahren nach Anspruch 8, ferner umfassend:
Berechnen eines durchschnittlichen Stellenplanitätswerts auf Grundlage der Messgröße der vollständigen Waferplanitätsmessung.

10. Verfahren nach Anspruch 9, ferner umfassend:
Subtrahieren des durchschnittlichen Stellenplanitätswerts von der Messgröße der vollständigen Waferplanitätsmessung, um eine Abweichung von Stelle zu Stelle zu erlangen.

11. Verfahren nach Anspruch 10, ferner umfassend:
Bereitstellen der Abweichung von Stelle zu Stelle als eine Rückkopplungsregelung an ein Verarbeitungswerkzeug, um durch das Verarbeitungswerkzeug induzierte Planitätsfehler zu reduzieren.

12. System, umfassend:
ein Geometriemessungswerkzeug für einen strukturierten Wafer; und
einen oder mehrere Prozessoren, die dazu konfiguriert sind, einen Satz von Anweisungen auszuführen, wobei der Satz von Anweisungen dazu konfiguriert ist, den einen oder die mehreren Prozessoren dazu zu veranlassen, das Verfahren nach einem der Ansprüche 1-11 zu implementieren, wobei der erste Satz von Wafergeometriemessungen des Wafers von dem Geometriewerkzeug für einen strukturierten Wafer erlangt wird.

## Revendications

1. Procédé pour contrôler des erreurs de mise au point de lithographie, le procédé comprenant :
l'obtention d'un premier ensemble de mesures géométriques de plaquettes d'une plaquette avant le balayage lithographique, le premier ensemble de mesures géométriques de plaquettes comportant : une première mesure de hauteur de face avant, une première mesure de hauteur de face arrière et une première mesure de planéité de plaquette ;
l'identification d'au moins une erreur de planéité de plaquette ; et
la commande d'un dispositif de balayage lithographique pour compenser l'au moins une erreur de planéité de plaquette pendant le balayage lithographique ;
dans lequel l'identification d'au moins une erreur de planéité de plaquette comprend :
l'obtention d'une carte de variation d'épaisseur au niveau de la plaquette ;
la division de la carte de variation d'épaisseur au niveau de la plaquette en une pluralité de sites de taille uniforme ;
le nivellement indépendant de chaque site de la pluralité de sites ;
la division en outre de chaque site en une pluralité de zones rectangulaires, dans lequel chaque zone rectangulaire correspond généralement à une taille de fente d'un dispositif de balayage lithographique ;
le nivellement indépendant de chaque zone rectangulaire de la pluralité de zones rectangulaires pour chaque site de la pluralité de sites ; et
la combinaison de la pluralité de zones rectangulaires de chaque site de la pluralité de sites pour obtenir une métrique de mesure de plaquette complète.

2. Procédé selon la revendication 1, dans lequel l'identification d'au moins une erreur de planéité de plaquette comprend en outre :
l'estimation d'au moins une erreur de planéité induite par mandrin de lithographie ; et
le calcul d'une erreur de planéité de plaquette totale sur la base de l'au moins une erreur de planéité induite par mandrin de lithographie et la première mesure de planéité de plaquette.

3. Procédé selon la revendication 2, dans lequel l'au moins une erreur de planéité induite par mandrin de lithographie est estimée en soustrayant la géométrie de plaquette d'une plaquette de référence mesurée dans un état non mandriné d'une carte de nivellement de la plaquette de référence obtenue à partir du dispositif de balayage lithographique lorsque la plaquette de référence est mandrinée.

4. Procédé selon la revendication 1, comprenant en outre :
l'obtention d'au moins l'une parmi : une erreur de mise au point et une uniformité de dimension critique, après le balayage lithographique.

5. Procédé selon la revendication 4, comprenant en outre :
la détermination d'une efficacité dudit contrôle du dispositif de balayage lithographique pour compenser l'au moins une erreur de planéité de plaquette pendant le balayage lithographique sur la base de ladite au moins une parmi : l'erreur de mise au point et l'uniformité de dimension critique, obtenue après le balayage lithographique ; et
le réglage de la mise au point lithographique sur la base de ladite au moins une parmi : l'erreur de mise au point et l'uniformité de dimension critique, obtenue après le balayage lithographique.

6. Procédé selon la revendication 1, dans lequel le nivellement indépendant de chaque site de la pluralité de sites comprend le réglage d'un plan unique le mieux ajusté par la méthode des moindres carrés à chaque site.

7. Procédé selon la revendication 1, dans lequel le nivellement indépendant de chaque zone rectangulaire de la pluralité de zones rectangulaires pour chaque site de la pluralité de sites comprend l'ajustement d'un plan unique le mieux ajusté par la méthode des moindres carrés à chaque zone rectangulaire.

8. Procédé selon la revendication 1, dans lequel la métrique de mesure de plaquette complète comporte une métrique de mesure de planéité de plaquette complète.

9. Procédé selon la revendication 8, comprenant en outre :
le calcul d'une valeur de planéité de site moyenne sur la base de la métrique de mesure de planéité de plaquette complète.

10. Procédé selon la revendication 9, comprenant en outre :
la soustraction de la valeur de planéité de site moyenne de la métrique de mesure de planéité de plaquette complète pour obtenir une variation de site à site.

11. Procédé selon la revendication 10, comprenant en outre :
la fourniture de la variation de site à site en tant que contrôle de rétroaction à un outil de traitement pour réduire les erreurs de planéité induites par l'outil de traitement.

12. Système comprenant :
un outil de mesure géométrique de plaquette à motifs ; et
un ou plusieurs processeurs configurés pour exécuter un ensemble d'instructions, dans lequel l'ensemble d'instructions sont configurées pour amener les un ou plusieurs processeur à mettre en œuvre le procédé selon l'une quelconque des revendications 1 à 11, dans lequel le premier ensemble de mesures géométriques de plaquettes est obtenu à partir de l'outil de géométrie de plaquette à motifs.
